Europäisches Patentamt

**European Patent Office**

Office européen des brevets

(11) Veröffentlichungsnummer: **0 217 355**
A2

(12) # EUROPÄISCHE PATENTANMELDUNG

(21) Anmeldenummer: **86113429.4**

(22) Anmeldetag: **30.09.86**

(51) Int. Cl.⁴: **H 05 K 9/00**

(30) Priorität: **02.10.85 DE 3535087**

(43) Veröffentlichungstag der Anmeldung:
**08.04.87 Patentblatt 87/15**

(84) Benannte Vertragsstaaten:
**BE DE FR GB IT NL SE**

(71) Anmelder: **Zeis, Hans-Jürgen
Nordring 77
D-8500 Nürnberg 10(DE)**

(72) Erfinder: **Zeis, Hans-Jürgen
Nordring 77
D-8500 Nürnberg 10(DE)**

(74) Vertreter: **LOUIS, PÖHLAU, LOHRENTZ & SEGETH
Kesslerplatz 1 P.B. 3055
D-8500 Nürnberg(DE)**

(54) **Abschirmung für elektronische Baugruppen.**

(57) Eine Abschirmung für elektronische Baugruppen besteht zur Erfüllung der unterschiedlichen Anforderungen wie Feuersicherheit, Biegsamkeit, Kurzschlußsicherheit und möglichst billiger Herstellbarkeit aus einer Aluminiumfolie, einer hoch verdichteten und kalt gewalzten Preßspanschicht sowie aus einer auf der zur Aluminiumfolie entgegengesetzten Seite der Preßspanschicht aufkaschierten Klarsichtfolie mit jeweils entsprechenden kritischen Werten.

EP 0 217 355 A2

- 1 -

Abschirmung für elektronische Baugruppen
-------------------------------------------

Die Erfindung betrifft eine Abschirmung für elektronische Baugruppen, die eine Holzstoffpappschicht und eine auf die Holzstoffpappe aufkaschierte Metallfolie umfasst.

Derartige Abschirmungen, die die elektronischen Baugruppen gegen elektromagnetische Störfelder schützen sollen, sind bekannt. Die bekannten Abschirmungen genügen aber nicht den zahlreichen, zum Teil widersprechenden Anforderungen, die an sie gestellt werden. So soll beispielsweise die Abschirmung auf der einen Seite biegsam sein in dem Sinne, dass sie um eine Biegekante umgebogen werden kann, die beispielsweise einer Gehäusekante für die elektronische Baugruppe entspricht. Aus diesem Aspekt heraus wäre eine möglichst dünne Metallfolie wünschenswert. Andererseits aber soll die Metallfolie beim Umbiegen nicht reissen. Wäre die Aluminiumfolie z.B. 30 μ stark, so würde sie beim Abbiegen brechen bzw. reissen, und die elektronische Leitfähigkeit wäre unterbrochen.

Aus diesem Grunde darf die Metallfolie wiederum nicht zu dünn/dick und die Holzpappschicht zu dick gewählt werden. Ferner soll die Abschirmung weitgehendst feuersicher sein und die Anforderungen, die in der Listung UL 94 festgelegt sind, erfüllen.

Eine weitgehend feuersichere Holzstoffpappe ist aber in hohem Masse hygroskopisch. Die Folge davon ist, dass, wenn die Abschirmung auf der zur Metallfolie entgegengesetzten Seite Kontaktstellen der elektronischen Baugruppen berührt, die Abschirmung Kurzschlüsse verursacht. Schliesslich soll die Abschirmung vor allen Dingen auch noch billig sein.

Der Erfindung liegt daher die Aufgabe zugrunde, eine Abschirmung der angesprochenen Art derart auszubilden, dass die oben erwähnten Anforderungen erfüllt werden, nämlich, dass sie umgebogen werden kann, ohne zu reissen, dass sie feuersicher ist, dass sie keine Kurzschlüsse verursacht, und dass sie vor allen Dingen auch noch billig ist.

Diese Aufgabe wird erfindungsgemäss dadurch gelöst, dass die Holzstoffpappe hoch verdichtet und mit Chemikalien zur Erhöhung der Feuersicherheit getränkt ist und ihre Dicke kleiner als 0,4 mm gewählt wird, dass die Dicke der Metallfolie kleiner als 20 µ, vorzugsweise ca. 9 bis 10 µ, gewählt wird, und dass auf der zur Metallfolie entgegengesetzten Seite der Holzstoffplatte eine Klarsichtfolie z.B. Zellophan, Polypropylen, Azetat oder Polyester mit einer Dicke von weniger als 15 µ aufkaschiert wird.

Es wurde herausgefunden, dass eine Abschirmung mit den oben angegebenen Merkmalen, insbesondere den kritischen Werten, alle angesprochenen Anforderungen gleichzeitig erfüllt. Ist die Dicke der feuerfesten Holzstoffpappe

kleiner als 0,4 mm, so lässt sie sich sehr gut umbiegen, ohne zu brechen, so dass auch die Metallfolie nicht reisst, auch wenn die Metallfolie so dünn wie angegeben gewählt wird. Deutlich unter 8 µ sollte allerdings die Alufolie nicht gewählt werden. Die Klarsichtfolie mit der angegebenen Dicke behindert die Biegefähigkeit der Abschirmung nicht und - wie Versuche klar gezeigt haben - erhöht auch nicht die Brenngefahr der Abschirmung, obwohl die Substanz der Klarsichtfolie selbst sehr gut brennt, wenn sie in einer grösseren Menge vorkommt. Sie wird auch beim Umbiegen der Abschirmung nicht reissen. Sie schützt aber andererseits die Holzstoffpappe vor dem Eindringen von Feuchtigkeit und somit einem Alterungsprozess und wirkt selbst auch isolierend, so dass Kurzschlüsse mit Sicherheit vermieden werden.

Vorzugsweise besteht die Holzstoffpappschicht aus Preßspan SE, der die Forderung bezüglich Feuersicherheit Listung UL 94 erfüllt.

Bei der Metallfolie handelt es sich zweckmässigerweise um eine Aluminiumfolie mit einem 99%igen Reinheitsgrad.

Zum Schluss ist noch zu bemerken, dass trotz der Erfüllung aller Anforderungen die angegebene Abschirmung äusserst billig herzustellen ist, weil eben unter anderem der Materialaufwand kleingehalten werden kann.

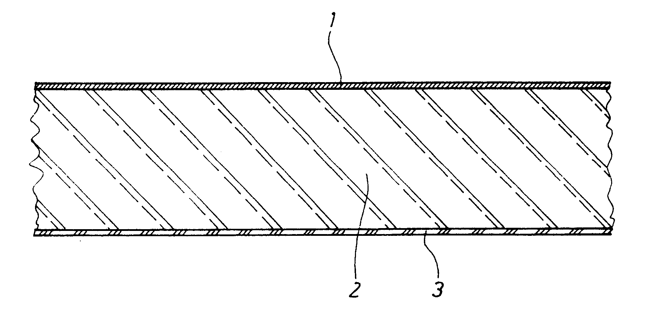

In der beiliegenden Zeichnung ist die Erfindung schematisch veranschaulicht.
Dort ist mit dem Bezugszeichen 1 eine Metallfolie, mit dem Bezugszeichen 2 eine Holzstoffpappschicht, die hoch verdichtet und kaltgewalzt ist und der Listung UL 94 genügt, und mit dem Bezugszeichen 3 eine Klarsichtfolie aus

Zellophan, Polypropylen, Azetat oder Polyester oder irgendeinem anderen geeigneten Material bezeichnet. Die Alufolie hat eine Dicke von 20 bis 8 μ, vorzugsweise von 9 bis 10 μ, während die Preßspanschicht eine Dicke von weniger als 0,4 aber mehr als 0,2 mm aufweist und die Klarsichtfolie eine Dicke von weniger als 15 μ und mehr als 5 μ hat.

- I -

Patentansprüche -:
- - - - - - - - - - - - - - - - - -

1.  Abschirmung für elektronische Baugruppen, die eine Holzstoffpappschicht und eine auf die Holzstoffpappe aufkaschierte Metallfolie umfasst, d a d u r c h   g e k e n n z e i c h n e t , dass die Holzstoffpappe (2) hochverdichtet und mit Chemikalien zur Erhöhung der Feuersicherheit getränkt ist und ihre Dicke kleiner als 0,4 mm ist, dass die Dicke der Metallfolie kleiner als 20 μ, vorzugsweise ca. 9 - 10 μ, ist, und dass auf der zur Metallfolie (1) entgegengesetzten Seite der Holzstoffpappe (2) eine Klarsichtfolie (3) aus Zellophan, Polypropylen, Azetat oder Polyester oder dergleichen mit einer Dicke von weniger als 15 μ aufkaschiert ist.

2.  Abschirmung nach Anspruch 1, d a d u r c h   g e k e n n z e i c h n e t , dass die Holzstoffpappschicht Preßspan SE ist.

3. Abschirmung nach Anspruch 1 oder 2, dadurch gekennzeichnet , dass die Metallfolie eine Aluminiumfolie mit einem 99%igen Reinheitsgrad ist.